# EUROPEAN PATENT SPECIFICATION

(11) **EP 2 774 453 B1**
(45) Date of publication and mention of the grant of the patent: **05.08.2015**
(21) Application number: 12772766.7
(22) Date of filing: 08.10.2012
(51) Int. Cl.: H05B 6/06, H02M 7/537, H03K 17/08

(54) **AN INDUCTION HEATING COOKER**
INDUKTIONSHERD
CUISEUR À INDUCTION

(30) Priority: 03.11.2011 TR 201110994
(43) Date of publication of application: 10.09.2014
(73) Proprietor: Arçelik Anonim Sirketi, 34950 Istanbul (TR)
(72) Inventor: YILMAZ, Namik, 34950 Istanbul (TR); OZTURK, Metin, 34950 Istanbul (TR); YARDIBI, Hakan Suleyman, 34950 Istanbul (TR)
(86) International application number: PCT/EP2012/069855
(87) International publication number: WO 2013/064332

(56) References cited:
- DE-A1-102005 020 805
- US-A- 5 986 484
- HIROTA I ET AL: "Performance evaluations of single-ended quasi-load resonant inverter incorporating advanced-2nd generation IGBT for soft switching", POWER ELECTRONICS AND MOTION CONTROL. SAN DIEGO, NOV. 9 - 13, 1992; [PROCEEDINGS OF THE INTERNATIONAL CONFERENCE ON INDUSTRIAL ELECTRONICS, CONTROL, INSTRUMENTATION AND AUTOMATION (IECON)], NEW YORK, IEEE, US, vol. CONF. 18, 9 November 1992 (1992-11-09), pages 223-228, XP010060719, DOI: 10.1109/IECON.1992.254629 ISBN: 978-0-7803-0582-3

## Description

The present invention relates to an induction heating cooker comprising electronic components that carry high current.

The induction heating cooker functions according to the principle of heating a cast iron or steel ferromagnetic cooking container with the magnetic field effect generated by the induction coil. In the state of the art, the half bridge series resonant (HBSR) circuits realized by using two power switches and two resonant capacitors, and the single switch quasi resonant (SSQR) circuits realized by one power switch and one resonant capacitor are used for driving a single induction coil. The single switch quasi resonant circuits (SSQR) are preferred due to cost advantage however they function in narrower energy frequency range and can deliver power to the cooking container only within a certain voltage and power range. Peak currents pass through the power switch (IGBT-Insulated Gate Bipolar Transistor) on the circuit board at the moment of vessel detection and at the moment of initial energizing. Besides vessel detection and initial energizing, when heating operation is desired to be performed at the low power level adjustment, that is called light-load, the resonant capacitor cannot be fully discharged and the power switch is subjected to peak currents when in transmission state. The high amplitude peak currents result in the power switch to be damaged in a short time and the service life of the induction heating cooker decreases.

In the United States Patent Application No. US2010006563, an induction heating device operating method is explained.

In the article titled "Induction Cooking Systems with Single Switch Inverter Using New driving Techniques" published by the Zaragoza University, methods are proposed that relate to decreasing the high amplitude peak currents to which the power switch is subjected in the induction heating cooker.

The aim of the present invention is the realization of an inducting heating cooker wherein the power switch driving the quasi resonant circuit is prevented from damage by decreasing the high amplitude peak currents.

The induction heating cooker realized in order to attain the aim of the present invention, explicated in the first claim and the respective claims thereof, comprises a parallel resonant circuit having an induction coil and a resonant capacitor connected in parallel to the induction coil, a power switch which drives the parallel resonant circuit, a collector, an emitter and a gate disposed on the power switch, a collector node whereto the collector is connected, a voltage measuring unit that detects the resonant voltage on the collector node, a control unit that changes the power switch to the closed and the open positions depending on the resonant voltage value, a drive circuit that provides the power switch to be driven with the drive voltage and a gate-emitter capacitor connected between the gate and emitter terminals of the power switch, providing the power switch to pass from the open position to the closed position by being charged with the drive voltage, and a resistance changing circuit connected between the drive circuit and the gate-emitter capacitor, the control unit providing the value of the drive current delivered to the power switch to be changed by changing the resistance value applied by the resistance changing circuit.

In an embodiment of the present invention, the resistance changing circuit comprises two resistors connected in series, a by-pass line connected in parallel to the second resistor and a switch disposed on the by-pass line.

In this embodiment, the by-pass line is deactivated by opening the switch and the second resistor is activated when peak currents affect the power switch at moments of detecting the vessel and delivering the initial energy. Thus, the total resistance value applied by the resistance changing circuit is increased, the time elapsed when the power switch starts conducting is increased and thus the peak currents acting on the power switch are decreased. In situations when peak currents do not act on the power switch, that is in times other than vessel detection and initial energy delivery, the by-pass line is activated by closing the switch and the second resistor is deactivated. Thus, the power switch is accelerated by decreasing the resistance value applied by the resistance changing circuit.

In another embodiment of the present invention, the resistance changing circuit comprises two resistors connected in parallel and a switch connected in series to the second resistor.

In this embodiment, the second resistor is deactivated by opening the switch in moments when peak currents act on the power switch. Thus, the resistance value applied by the resistance changing circuit is increased and the peak currents acting on the power switch are decreased. In

situations when the peak currents do not act on the power switch, the second resistor is activated by closing the switch. Thus, the power switch is accelerated by decreasing the resistance value applied by the resistance changing circuit.

In the induction heating cooker of the present invention, in moments of vessel detection and delivery of initial energy at the start of vessel heating process, the power switch is provided to pass slowly from the open position to the closed position by decreasing the drive current value delivered to the power switch. The peak currents passing through the power switch are decreased and the power switch is prevented from being damaged. In the steady state when peak currents are not observed, the value of the drive current applied to the power switch is increased and overheating of the power switch is prevented.

The induction heating cooker realized in order to attain the aim of the present invention is illustrated in the attached figures, where:
Figure 1 - is the schematic view of an induction heating cooker.
Figure 2 - is the schematic view of a resistance amplifier circuit in an embodiment of the present invention.

The elements illustrated in the figures are numbered as follows:
1. Induction heating cooker
2. Mains filtering circuit
3. Bridge rectifier
4. DC-line inductor
5. DC-line capacitor
6. Induction coil
7. Resonant capacitor
8. Parallel resonant circuit
9. Power switch
10. Collector
11. Emitter
12. Gate
13. Collector node
14. Voltage measuring unit
15. Control unit
16. Drive circuit
17. Gate-emitter capacitor
18. Resistance changing circuit
19. By-pass line
20. 120. Switch

The induction heating cooker (1) comprises a filtering circuit (2) that filters the AC mains voltage, a bridge rectifier (3) that converts the AC mains voltage into direct current, a DC-line inductor (4) and a DC-line capacitor (5) disposed at the output of the bridge rectifier (3) and which deliver DC voltage in a certain frequency range by filtering the voltage generated in the DC-line, a parallel resonant circuit (8) having an induction coil (6) that provides the vessel (K) placed thereon to be heated by the generated magnetic field and a resonant capacitor (7) connected in parallel to the induction coil (6), a power switch (9), for example an IGBT (Insulated Gate Bipolar Transistor), that drives the parallel resonant circuit (8), that is in conducting state in the closed position and provides the resonant capacitor (7) to be charged, providing the delivery of the energy stored in the resonant capacitor (7) to the vessel (K) by means of the induction coil (6) in the open position, a collector (10), an emitter (11), a gate (12) disposed on the power switch (9), a collector node (13) whereto the collector (10) is connected, whereon resonant voltage (Vce) is generated in the open position of the power switch (9), a voltage measuring unit (14) that detects the resonant voltage (Vce) on the collector node (13), a control unit (15), preferably a microcontroller, that changes the power switch (9) to closed and open positions depending on the voltage value (Vce) of the collector node (13), a drive circuit (16) that provides the power switch (9) to be driven with the required level of drive voltage (Vge) and a gate-emitter capacitor (17) connected between the gate (12) and emitter (11) terminals of the power switch (9), providing the power switch (9) to pass from the open position to the closed position by being charged with the drive voltage (Vge).

In the induction heating cooker (1), energy is stored in the induction coil (6) when the power switch (9) is in the closed position, and energy is delivered from the induction coil (6) to the vessel (K) in order to heat it when the power switch (9) is in the open position. When the induction heating cooker (1) is operated, a short term drive voltage (Vge), for example of 15V value in "pulse" form is applied to the gate (12) terminal of the power switch (9) by the control unit (15) by means of the drive circuit (16) for detecting the vessel (K), in the meantime the power switch (9) starts conducting by being changed to the closed position and the power switch (9) is subjected to high amplitude peak currents during the conducting time when it is closed. After the vessel (K) detection operation, the power switch (9) starts conducting for a while by being changed to the closed position at the start of the heating process, before delivery of initial energy to the vessel (K) and is subjected to high amplitude peak currents during the conducting time when it is closed. Furthermore, in the induction heating cooker (1), in the case of light-load wherein low power adjustment is made by the user, the power switch (9) is also subjected to high amplitude peak currents during the vessel (K) heating process in each of the closed positions it is changed to.

The induction heating cooker (1) of the present invention comprises,
- a resistance changing circuit (18) connected between the drive circuit (16) and the gate-emitter capacitor (17) and
- the control unit (15) that provides the value of the drive current (Ige) delivered to the power switch (9) to be changed by changing the resistance value applied by the resistance changing circuit (18).

In the induction heating cooker (1), the drive voltage (Vge) is applied to the gate-emitter capacitor (17) by the drive circuit (16) for the power switch (9) to pass from the open position to the closed position and after the gate-emitter capacitor (17) is charged by the drive voltage (Vge) for a certain time, the power switch (9) is provided to pass from the open position to the closed position. The control unit (15) changes the drive current (Ige) value delivered to the power switch (9) through the gate-emitter capacitor (17), the drive voltage (Vge) remaining constant, by controlling the resistance changing circuit (18) and provides the increase/decrease of the charge period of the gate-emitter capacitor (17) and accordingly passage time of the power switch (9) from the open position to the closed position wherein it starts conducting.

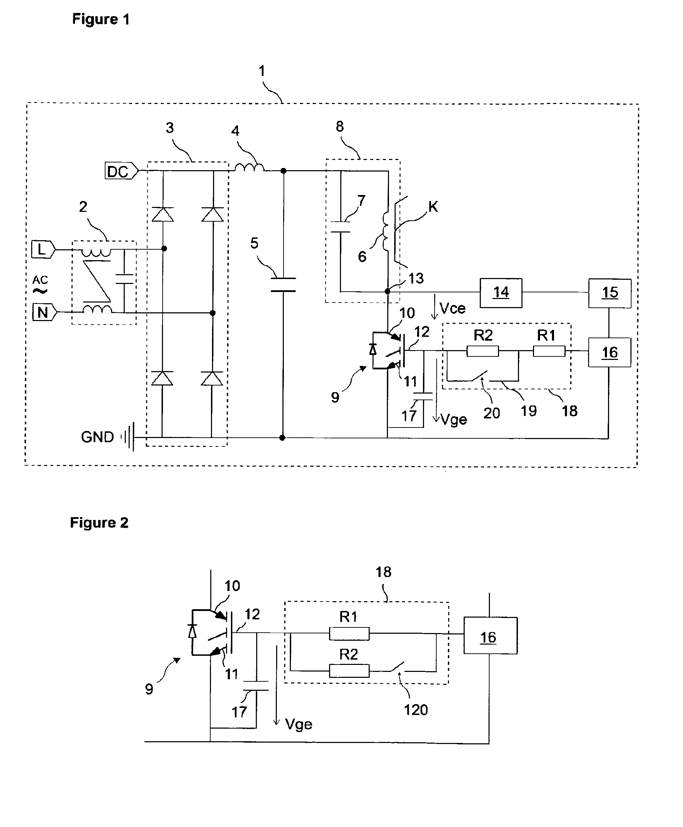

In an embodiment of the present invention, the resistance changing circuit (18) comprises two resistors (R1, R2) connected in series, a by-pass line (19) connected in parallel to the second resistor (R2) and a switch (20) disposed on the by-pass line (19) (Figure 1).

In this embodiment, the control unit (15) deactivates the by-pass line (19) by opening the switch (20) and activates the second resistor (R2) connected in series in situations where peak currents act on the power switch (9), at moments of vessel (K) detection, delivery of initial energy to the vessel (K) at the start of the heating process and in light-load conditions. Thus, the resistance applied by the resistance changing circuit (18) is increased, the drive current (Ige) value delivered to the power switch (9) from the drive circuit (16) is decreased. The charge period of the gate-emitter capacitor (17) and hence passage time of the power switch (9) from the open position to the closed position is increased and the power switch (9) is slowed down. The power switch (9) forms a resistance by itself against the high peak currents delivered as a result of the resonant capacitor (7) being discharged in the parallel resonant circuit (8) and the peak currents passing through the power switch (9) are decreased.

The control unit (15) activates the by-pass line (19) by closing the switch (20) and deactivates the second resistor (R2) connected in series except the moments of vessel (K) detection and initial energy delivery where peak currents do not act on the power switch (9) and in the steady state apart from the light-load condition. Thus, the resistance applied by the resistance changing circuit (18) is decreased and the value of the drive current (Ige) delivered to the power switch (9) from the drive circuit (16) is increased. The charge period of the gate-emitter capacitor (17) and hence passage time of the power switch (9) from the open position to the closed position is decreased and the power switch (9) is accelerated. The gate-emitter capacitor (17) is not forced to be continuously charged with low current (Ige) and the power switch (9) is prevented from overheating. In another embodiment of the present invention, the resistance changing circuit (18) comprises two resistors (R1, R2) connected in parallel and a switch (120) connected in series to the second resistor (R2) (Figure 2).

In this embodiment, the control unit (15), at the moments the peak currents act on the power switch (9), deactivates the second resistor (R2) connected in parallel by opening the switch (120), the drive current (Ige) delivered from the drive circuit (16) to the power switch (9) passes only through the first resistor (R1), thus the resistance applied by the resistance changing circuit (18) is increased, the value of the drive current (Ige) delivered to the power switch (9) is decreased, hence the peak currents acting on the power switch (9) are decreased.

The control unit (15) activates the second resistor (R2) connected in parallel by closing the switch (120) when peak currents do not act on the power switch (9), the drive current (Ige) delivered from the drive circuit (16) to the power switch (9) passes through two resistors (R1, R2) connected in parallel, thus the resistance applied by the resistance changing circuit (18) is decreased and the drive current (Ige) value delivered to the power switch (9) is increased. The gate-emitter capacitor (17) is not forced to be continuously charged with low current (Ige) and the power switch (9) is prevented from overheating.

In another embodiment of the present invention, the value of the first resistor (R1) is higher than the value of the second resistor (R2) in the resistance changing circuit (18).

In another embodiment of the present invention, the value of the first resistor (R1) is equal to the value of the second resistor (R2) in the resistance changing circuit (18).

In the induction heating cooker (1), the control unit (15) controls the drive current (Ige) delivered to the power switch (9) from the drive circuit (16) by means of the gate-emitter capacitor (17) by changing the resistance value applied by the resistance changing circuit (18).

The control unit (15) lowers the drive current (Ige) value by increasing the resistance applied by the resistance changing circuit (18) at the moments of vessel (K) detection, delivery of initial energy to the vessel (K) at the start of heating process and in light-load conditions, increases the charge period of the gate-emitter capacitor (17), provides the power switch (9) to pass from the open position to closed position slowly, decreases the peak currents passing through the power switch (9) and prevents the power switch (9) from being damaged. In the steady state where peak currents are not observed, the value of the drive current (Ige) applied to the power switch (9) is increased and overheating of the power switch (9) is prevented.

It is to be understood that the present invention is not limited by the embodiments disclosed above and a person skilled in the art can easily introduce different embodiments. These should be considered within the scope of the protection postulated by the claims of the present invention.

## Claims

1. An induction heating cooker (1) **comprising** a parallel resonant circuit (8) having an induction coil (6) and a resonant capacitor (7) connected in parallel to the induction coil (6), a power switch (9) which drives the parallel resonant circuit (8), a collector (10), an emitter (11) and a gate (12) disposed on the power switch (9), a collector node (13) whereto the collector (10) is connected, a voltage measuring unit (14) that detects the resonant voltage (Vce) on the collector node (13), a control unit (15) that changes the power switch (9) to the closed and the open positions depending on the resonant voltage value (Vce), and a drive circuit (16) that provides the power switch (9) to be driven with the drive voltage (Vge), **characterised in that** a gate-emitter capacitor (17) is connected between the gate (12) and emitter (11) terminals of the power switch (9), providing the power switch (9) to pass from the open position to the closed position by being charged with the drive voltage (Vge), and a resistance changing circuit (18) connected between the drive circuit (16) and the gate-emitter capacitor (17), the control unit (15) providing the value of the drive current (Ige) delivered to the power switch (9) to be changed by changing the resistance value applied by the resistance changing circuit (18).

2. An induction heating cooker (1) as in Claim 1, **characterized by** the resistance changing circuit (18) comprising two resistors (R1, R2) connected in series, a by-pass line (19) connected in parallel to the second resistor (R2) and a switch (20) disposed on the by-pass line (19).

3. An induction heating cooker (1) as in Claim 2, **characterized by** the control unit (15) that deactivates the by-pass line (19) by opening the switch (20) and activates the second resistor (R2) at moments when peak currents act on the power switch (9) thus providing the resistance applied by the resistance changing circuit (18) to be increased.

4. An induction heating cooker (1) as in Claim 2 and 3, **characterized by** the control unit (15) that activates the by-pass line (19) by closing the switch (20) and deactivates the second resistor (R2) at moments when peak currents do not act on the power switch (9) thus providing the resistance applied by the resistance changing circuit (18) to be decreased.

5. An induction heating cooker (1) as in Claim 1, **characterized by** the resistance changing circuit (18) comprising two resistors (R1, R2) connected in parallel and a switch (120) connected in series to the second resistor (R2).

6. An induction heating cooker (1) as in Claim 5, **characterized by** the control unit (15) that deactivates the second resistor (R2) by opening the switch (120) at moments when peak currents act on the power switch (9) thus providing the resistance applied by the resistance changing circuit (18) to be increased.

7. An induction heating cooker (1) as in Claim 5 and 6, **characterized by** the control unit (15) that activates the second resistor (R2) by closing the switch (120) at the condition when peak currents do not act on the power switch (9) thus providing the resistance applied by the resistance changing circuit (18) to be decreased.

8. An induction heating cooker (1) as in any one of the above Claims, **characterized by** the resistance changing circuit (18) wherein the value of the first resistor (R1) is higher than the value of the second resistor (R2).

9. An induction heating cooker (1) as in any one of the Claims 1 to 7, **characterized by** the resistance changing circuit (18) wherein the value of the first resistor (R1) is equal to the value of the second resistor (R2).

## Patentansprüche

1. Induktionserwärmungsherd (1), umfassend eine Parallelresonanzschaltung (8) mit einer Induktionsspule (6) und einen Resonanzkondensator (7), der parallel mit der Induktionsspule (6) geschaltet ist, einen Leistungsschalter (9), der die Parallelresonanzschaltung (8) antreibt, einen Kollektor (10), einen Emitter (11) und ein Gate (12), die an dem Leistungsschalter (9) angeordnet sind, einen Kollektorknoten (13), mit dem der Kollektor (10) verbunden ist, eine Spannungsmesseinheit (14), die die Resonanzspannung (Vce) an dem Kollektorknoten (13) erkennt, eine Steuereinheit (15), die abhängig vom Wert der Resonanzspannung (Vce) den Leistungsschalter (9) in die geschlossene und die offene Stellung umschaltet, und eine Antriebsschaltung (16), die dafür sorgt, dass der Leistungsschalter (9) mit der Antriebsspannung (Vge) angetrieben wird, **dadurch gekennzeichnet, dass** ein Gate-Emitter-Kondensator (17) zwischen dem Gate- (12) und dem Emitter- (11) Anschluss des Leistungsschalters (9) verbunden ist und dafür sorgt, dass der Leistungsschalter (9) aus der offenen Stellung in die geschlossene Stellung übergeht, indem er mit der Antriebsspannung (Vge) geladen wird, und eine Widerstandsänderungsschaltung (18) zwischen der Antriebsschaltung (16) und dem Gate-Emitter-Kondensator (17) verbunden ist, wobei die Steuereinheit (15) dafür sorgt, dass der Wert des Antriebsstroms (Ige), der an den Leistungssschalter (9) bereitgestellt wird, geändert wird, indem der Widerstandswert geändert wird, der von der Widerstandsänderungsschaltung (18) angewandt wird.

2. Induktionserwärmungsherd (1) nach Anspruch 1, **dadurch gekennzeichnet, dass** die Widerstandsänderungsschaltung (18) zwei Widerstände (R1, R2) umfasst, die über eine Kurzschlussleitung (19), die parallel mit dem zweiten Widerstand (R2) verbunden ist, in Reihe geschaltet sind, und ein Schalter (20) an der Kurzschlussleitung (19) angeordnet ist.

3. Induktionserwärmungsherd (1) nach Anspruch 2, **dadurch gekennzeichnet, dass** die Steuereinheit (15) die Kurzschlussleitung (19) durch Öffnen des Schalters (20) deaktiviert und den zweiten Widerstand (R2) aktiviert, wenn Spitzenströme am Leistungsschalter (9) anliegen, und dadurch dafür sorgt, dass der Widerstand, der von der Widerstandsänderungsschaltung (18) angewandt wird, erhöht wird.

4. Induktionserwärmungsherd (1) nach Anspruch 2 und 3, **dadurch gekennzeichnet, dass** die Steuereinheit (15) die Kurzschlussleitung (19) durch Schließen des Schalters (20) aktiviert und den zweiten Widerstand (R2) deaktiviert, wenn keine Spitzenströme am Leistungsschalter (9) anliegen, und dadurch dafür sorgt, dass der Widerstand, der von der Widerstandsänderungsschaltung (18) angewandt wird, gesenkt wird.

5. Induktionserwärmungsherd (1) nach Anspruch 1, **dadurch gekennzeichnet, dass** die Widerstandsänderungsschaltung (18) zwei Widerstände (R1, R2) umfasst, die parallel geschaltet sind, und einen Schalter (120) der mit dem zweiten Widerstand (R2) in Reihe geschaltet ist.

6. Induktionserwärmungsherd (1) nach Anspruch 5, **dadurch gekennzeichnet, dass** die Steuereinheit (15) den zweiten Widerstand (R2) durch Öffnen des Schalters (120) deaktiviert, wenn Spitzenströme am Leistungsschalter (9) anliegen, und dadurch dafür sorgt, dass der Widerstand, der von der Widerstandsänderungsschaltung (18) angewandt wird, erhöht wird.

7. Induktionserwärmungsherd (1) nach Anspruch 5 und 6, **dadurch gekennzeichnet, dass** die Steuereinheit (15) den zweiten Widerstand (R2) durch Schließen des Schalters (120) aktiviert, wenn keine Spitzenströme am Leistungsschalter (9) anliegen, und dadurch dafür sorgt, dass der Widerstand, der von der Widerstandsänderungsschaltung (18) angewandt wird, gesenkt wird.

8. Induktionserwärmungsherd (1) nach einem der vorangehenden Ansprüche, **dadurch gekennzeichnet, dass** bei der Widerstandsänderungsschaltung (18) der Wert des ersten Widerstands (R1) höher als der Wert des zweiten Widerstands (R2) ist.

9. Induktionserwärmungsherd (1) nach einem der vorangehenden Ansprüche, **dadurch gekennzeichnet, dass** bei der Widerstandsänderungsschaltung (18) der Wert des ersten Widerstands (R1) gleich dem Wert des zweiten Widerstands (R2) ist.

## Revendications

1. Un dispositif de chauffage à induction (1) comprenant un circuit parallèle de résonance (8) présentant une bobine d'induction (6) et un condensateur de résonance (7) relié en parallèle à la bobine d'induction (6), un interrupteur d'alimentation (9) qui entraîne le circuit parallèle de résonance (8), un collecteur (10), un émetteur (11) et une grille (12) disposés sur l'interrupteur d'alimentation (9), un noeud collecteur (13) auquel le collecteur (10) est relié, une unité de mesure de tension (14) qui détecte la tension de résonance (Vce) sur le noeud collecteur (13), une unité de commande (15) qui change l'interrupteur d'alimentation (9) entre les positions fermée et ouverte en fonction de la valeur de la tension de résonance (Vce), et un circuit d'entraînement (16) qui permet l'entraînement de l'interrupteur d'alimentation (9) avec la tension d'entraînement (Vge), **caractérisé en ce que** un condensateur grill-émetteur (17) est relié entre la grille (12) et l'émetteur (11) de l'interrupteur d'alimentation (9), qui permet à l'interrupteur d'alimentation (9) de passer de la position ouverte à la position fermée en étant chargé par la tension d'entraînement (Vge), et un circuit de changement de résistance (18) qui est relié entre le circuit d'entraînement (16) et le condensateur grill-émetteur (17), l'unité de commande (15) permettant le changement de la valeur du courant d'entraînement (Ige) fourni à l'interrupteur d'alimentation (9) en changeant la valeur de résistance appliquée par le circuit de changement de résistance (18).

2. Un dispositif de chauffage à induction (1) selon la Revendication 1, **caractérisé par** le circuit de changement de résistance (18) comprenant deux résistances (R1, R2) reliées en série, une ligne de by-pass (19) reliée en parallèle à la deuxième résistance (R2) et un interrupteur (20) disposé sur la ligne de by-pass (19).

3. Un dispositif de chauffage à induction (1) selon la Revendication 2, **caractérisé par** l'unité de commande (15) qui désactive la ligne de by-pass (19) en ouvrant l'interrupteur (20) et active la deuxième résistance (R2) à des moments où des courants de crête agissent sur l'interrupteur d'alimentation (9), donc permettant l'augmentation de la résistance appliquée par le circuit de changement de résistance (18).

4. Un dispositif de chauffage à induction (1) selon la Revendication 2 et 3, **caractérisé par** l'unité de commande (15) qui active la ligne de by-pass (19) en fermant l'interrupteur (20) et désactive la deuxième résistance (R2) à des moments où des courants de crête n'agissent pas sur l'interrupteur d'alimentation (9), donc permettant la réduction de la résistance appliquée par le circuit de changement de résistance (18).

5. Un dispositif de chauffage à induction (1) selon la Revendication 1, **caractérisé par** le circuit de changement de résistance (18) comprenant deux résistances (R1, R2) reliées en parallèle et un interrupteur (120) qui est relié en série à la deuxième résistance (R2).

6. Un dispositif de chauffage à induction (1) selon la Revendication 5, **caractérisé par** l'unité de commande (15) qui désactive la deuxième résistance (R2) en ouvrant l'interrupteur (120) à des moments où des courants de crête agissent sur l'interrupteur d'alimentation (9), donc permettant l'augmentation de la résistance appliquée par le circuit de changement de résistance (18).

7. Un dispositif de chauffage à induction (1) selon la Revendication 5 et 6, **caractérisé par** l'unité de commande (15) qui active la deuxième résistance (R2) en fermant l'interrupteur (120) si des courants de crête n'agissent pas sur l'interrupteur d'alimentation (9), donc permettant la réduction de la résistance appliquée par le circuit de changement de résistance (18).

8. Un dispositif de chauffage à induction (1) selon l'une quelconque des revendications précédentes, **caractérisé par** le circuit de changement de résistance (18) où la valeur de la première résistance (R1) est supérieure à la valeur de la deuxième résistance (R2).

9. Un dispositif de chauffage à induction (1) selon l'une quelconque des revendications de 1 à 7, **caractérisé par** le circuit de changement de résistance (18) où la valeur de la première résistance (R1) est égale à la valeur de la deuxième résistance (R2).
